(19) **Europäisches Patentamt**

**European Patent Office**

**Office européen des brevets**

(11) **EP 0 488 628 B1**

(12) **EUROPEAN PATENT SPECIFICATION**

(45) Date of publication and mention
of the grant of the patent:
**10.05.2000 Bulletin 2000/19**

(51) Int. Cl.[7]: **H01L 21/285**, H01L 21/768,
H01L 21/3205

(21) Application number: **91310843.7**

(22) Date of filing: **26.11.1991**

(54) **Method of producing an aluminum stacked contact/via for multilayer interconnections**

Verfahren zum Herstellen von gestapelten Verbindungs/kontaktlöchern aus Aluminium für
Mehrschichtverbindungen

Méthode de fabrication d'un trou de liaison/contact empilées en aluminium pour des interconnexions
à multi-couches

(84) Designated Contracting States:
**DE FR GB IT**

(30) Priority: **30.11.1990 US 621367**

(43) Date of publication of application:
**03.06.1992 Bulletin 1992/23**

(73) Proprietor:
**STMicroelectronics, Inc.**
**Carrollton, TX 75006-5039 (US)**

(72) Inventors:
- **Liou, Fu-Tai**
  **Carrollton, Texas 75010 (US)**
- **Chen, Fusen E.**
  **Dallas, Texas 75287 (US)**

(74) Representative:
**Palmer, Roger et al**
**PAGE, WHITE & FARRER**
**54 Doughty Street**
**London WC1N 2LS (GB)**

(56) References cited:
| | |
|---|---|
| EP-A- 0 107 259 | EP-A- 0 132 720 |
| EP-A- 0 137 701 | EP-A- 0 273 715 |
| EP-A- 0 329 227 | EP-A- 0 351 001 |
| EP-A- 0 430 403 | GB-A- 2 112 566 |
| GB-A- 2 128 636 | US-A- 5 108 570 |

- VMIC Conf.,June 12-13,1990,IEEE,TH-0325-1/90 H. Ono et al.:"Development of a Planarized Al-Si Contact Filling Technology",pp.76-82
- 4th Intl. IEEE VLSI Multilevel Interconnection Conference,June 15-16,1987,Santa Clara,USA, E. Demaray et al.:"Aluminum Alloy Planarization for Topography Control of Multilevel VLSI Interconnect",pp.371-375
- IEEE ELECTRON DEVICE LETTERS. vol. EDL-8, no. 10, October 1987, NEW YORK US pages 503 - 505; S.-N. MEI ET AL.: 'Nonconformal Al Via Filling and Planarization by Partially Ionized Beam Deposition for Multilevel Interconnection'
- SOLID STATE TECHNOLOGY. vol. 33, no. 3, March 1990, WASHINGTON US pages 73 - 79; D. PRAMANIK ET AL.: 'Aluminum Metallization for ULSI'
- JOURNAL OF VACUUM SCIENCE AND TECHNOLOGY vol. 6A(3), May/June 1998, pages 1636-1639

## Description

The present invention relates generally to semiconductor integrated circuit processing, and more specifically to producing an aluminum stacked contact/via for multilayer interconnections.

Solid State Technology, 33 (1990) March, No. 3, Westford, MA, US, pp 73-79 "Aluminum Metallisation for ULSI"; Journal of Vacuum Science and Technology, A6(3), May/June 1988, pp 1636-1639; and US Patent No. 5,108,570 all discuss the fabrication of aluminum plugs. These references all use the terms "aluminum" and "aluminum alloy" interchangeably, and it is well understood by those skilled in the art that in relation to the formation of plugs, reference to "aluminum" is reference to a metallic material consisting essentially of aluminum, i.e. an aluminum alloy.

Metal films are used extensively in the field of semiconductor integrated circuit fabrication for surface wiring. The metallization process of wiring components together begins with etching contact openings or vias through the various layers down to the active regions within a semiconductor substrate, or to contact an underlying polycrystalline silicon or a metal interconnect layer. A conductive metal is then deposited over the surface of the wafer in a manner that provides good contact with the underlying active device. Increasing chip density and smaller geometries have decreased the available area for surface wiring. Multilevel metal arrangements have solved part of this problem.

Because of its physical properties, aluminum is especially well suited for fabrication of metal interconnects. Among the properties which make aluminum so useful is the fact that it is very conductive, it forms a good mechanical bond with various dielectric layers generally used in the semiconductor industry, and it makes a good ohmic contact with both N and P type semiconductors. However, the sputtering process used to apply aluminum thin film layers to an integrated circuit generally results in less than ideal filling of contact vias. Large aluminum grains tend to form on the upper surface of the insulating layer. These grains which form at the edges of the contact via tend to block the contact opening before the aluminum has a chance to completely fill the contact via. This blockage produces a thinner layer of aluminum along the sides of the insulating layer, increasing the current density through that part of the contact opening and resulting in voids and uneven structures within the via. This problem is enhanced as circuit devices are fabricated using smaller geometries.

The uneven thickness of the aluminum layer going into the via, caused by the step coverage problem described above, has an adverse impact on device functionality. If the voids in the via are large enough, contact resistance can be significantly higher than desired. In addition, the thinner regions of the aluminum layer will be subject to the well known electromigration problem. This problem can cause eventual open circuits at the contacts and premature failure of the devices. The devices must be designed so that the current density in the aluminum interconnect lines does not become high enough to cause rapid electromigration. The thinner regions of the aluminum layer tend to occur over abrupt height changes on the surface of the integrated circuit.

Many approaches have been used to try to ensure good metal contact to lower interconnect levels. For example, refractory metal layers have been used in conjunction with the aluminum interconnect layer to improve conduction through a via. Sloped via sidewalls have been used to improve metal filling in the via. The use of sloped sidewalls is becoming less common as device sizes shrink because they consume too much area on a chip.

Even with these techniques, the problems of completely filling a via with aluminum are not solved. In part, this is due to the fact that aluminum is deposited at a temperature which tends to encourage fairly large grain sizes. Voids and other irregularities within the contact continue to be problems with current technologies.

European patent application publication Nos. 0351001 and 0107259 each disclose techniques for depositing aluminum in a contact via in a two stage deposition process. Each of the two stages of the respective deposition processes have process conditions associated therewith which do not vary.

One technique which has been proposed to overcome the via filling problem is to deposit the aluminum interconnect layers at a temperature between 500 degrees C and 550 degrees C. At these temperatures, the liquidity of the aluminum is increased, allowing it to flow down into the vias and fill them. This technique is described, for example, in DEVELOPMENT OF A PLANARIZED Al-Si CONTACT FILLING TECHNOLOGY, H. Ono et al, June 1990 VMIC Conference proceedings, pages 76-82. At temperatures below 500 degrees C and above 550 degrees C result in degraded metal filling of contact vias. It is believed that use of such technique still suffers from problems caused by large grain sizes.

European patent application publication No. 0273715 discloses a solution for dealing with a particular problem associated with depositing a single layer of aluminum in a contact via at a fixed, elevated wafer temperature.

It would be desirable to provide a technique for manufacturing integrated circuits whereby contact openings are completely filled improving coverage in contact vias. It is further desirable that such a technique be compatible with current standard process flows.

It is therefore an object of the present invention to provide a semiconductor fabrication technique for forming an aluminum contact on an integrated circuit.

It is another object of the present invention to provide such a method in which aluminum fills the contact via while eliminating voids being formed therein.

It is a further object of the present invention to provide such a method which is suitable for use at one micrometer and submicrometer geometries.

It is yet another object of the present invention to provide such a method which is compatible with current process technology.

Therefore, according to the present invention, a method is provided for depositing improved quality aluminum thin film interlevel contacts in a semiconductor integrated circuit. A contact opening is formed through an insulating layer. A barrier layer is deposited over the surface of the integrated circuit chip. An aluminum layer is deposited at relatively low deposition rates at a temperature which allows improved surface migration of the deposited aluminum atoms. Aluminum deposited under these conditions tends to fill contact vias without the formation of voids. The low temperature deposition step can be initiated by deposition of aluminum while a wafer containing the integrated circuit device is being heated from cooler temperatures within the deposition chamber. Formation of the aluminum contact under these conditions helps to fill the contact opening and provide a smooth upper contour to the deposited aluminum layer so that additional aluminum contacts may be formed on top of the first aluminum contact.

According to a further aspect of the present invention there is provided a method of forming interlevel aluminum contacts in integrated circuits, comprising the steps of forming a first insulating layer over a conducting layer, forming a first contact opening through the insulating layer to expose a portion of the conducting layer, depositing a first barrier layer, selected from a refractory metal alloy, a refractory metal silicide, a refractory metal nitride, a refractory metal or a composite thereof, over the first insulating layer and in the opening, depositing a first, layer of aluminum continuously on the integrated circuit while the temperature of the integrated circuit is raised from below approximately 350°C to a desired value between approximately 400°C and approximately 500°C, after the integrated circuit temperature has reached the desired temperature, depositing the first layer of aluminum on the integrated circuit to desired thickness, during the step of depositing the first layer of aluminum to the desired thickness, controlling the rate at which the aluminum is deposited to be less than approximately (.7 * T) - 25 nm/sec wherein T lies between approximately 400°C and approximately 500°C, wherein deposited aluminum migrates into the opening so as to provide a substantially complete contact fill, forming a second insulating layer disposed over the first layer of aluminum and the first insulating layer, forming a second contact opening in the second insulating layer, wherein the second contact opening exposes a portion of the first layer of aluminum, depositing a second barrier layer, selected from a refractory metal alloy, a refractory metal silicide, a refractory metal nitride, a refractory metal or a composite thereof, over the second insulating layer and in the second contact opening, depositing a second layer of aluminum continuously on the integrated circuit while the temperature of the integrated circuit is raised from below approximately 350°C to a desired value between approximately 400°C and approximately 500°C, after the integrated circuit temperature has reached the desired temperature, depositing the second layer of aluminum on the integrated circuit to a desired thickness and during the step of depositing the second layer of aluminum to a desired thickness, controlling the rate at which the aluminum is deposited to be less than approximately (.7 * T) - 25 nm/sec wherein T lies between approximately 400°C and approximately 500°C, wherein deposited aluminum migrates into the second contact opening so as to provide a substantially complete contact fill.

The novel features believed characteristic of the invention are set forth in the appended claims. The invention itself, However, as well as a preferred mode of use, and further objects and advantages thereof, will best be understood by reference to the following detailed description of an illustrative embodiment when read in conjunction with the accompanying drawings, wherein:

Figures 1-3 illustrate a preferred method for fabricating an interlevel aluminum contact according to the present invention.

Figure 4 is a graph illustrating preferred process conditions for formation of an aluminum contact.

Figure 5 illustrates several alternative deposition rate diagrams for forming aluminum contacts according to the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

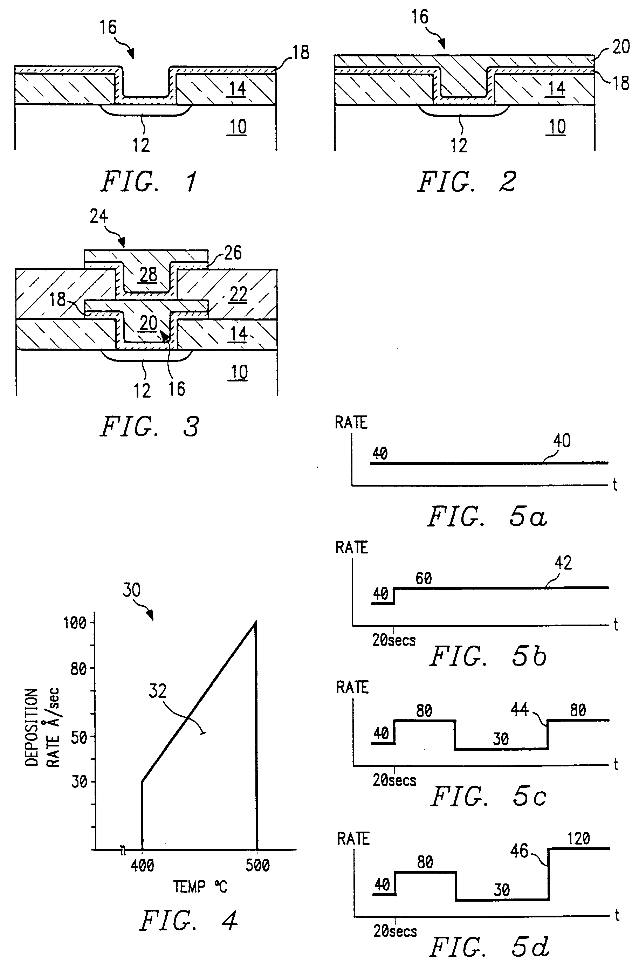

Referring to Figure 1, a substrate 10 includes an active region 12 such as a source/drain region of a field effect transistor. An insulating layer 14, such as a reflow glass or other oxide layer as known in the art, is formed over the substrate 10 and planarized. Layer 14 typically has a thickness on the order of approximately 500 to 1000 nm. A contact via 16 is formed in the insulating layer 14 in order to allow an upper level conductor to make contact with the active region 12.

A barrier metal layer 18, such as a refractory metal alloy, is deposited over the surface of the integrated circuit as known in the art. Layer 18 is relatively thin, typically approximately 1000 to 200 nm thick, and is deposited conformally to cover the bottom and sidewalls of contact opening 16. The purpose of the barrier metal layer is to act as a diffusion barrier and to lower the contact resistance. The barrier metal layer may also be a refractory metal silicide, refractory metal nitride or a composite layer such as a refractory metal/refractory metal nitride, refractory metal/refractory metal silicide or refractory metal silicide/refractory metal nitride. A composite layer using a refractory metal underlying a refractory metal nitride or refractory metal silicide provides for good adhesion to the insulating layer 14 and reduces contact/via resistance.

Referring to Figure 2, an aluminum layer 20 is deposited over the surface of the device. The aluminum layer 20 does not alloy or react with the barrier metal layer 18. However, when the aluminum layer 20 is deposited using the process conditions described below, the layer 20 completely fills in the contact via 16 and tends toward leveling the upper surface of the aluminum layer 20 as shown in **Figure 2**. The completely filled contact via 16 occurs because the preferred process conditions enhance the surface migration of the deposited aluminum atoms, so that aluminum forms in the bottom of the via 16 preferentially to formation on the oxide layer 14 near the edges of the via 16. The process conditions described below provide for a relatively flat upper surface for aluminum layer 20, and this effect tends to improve the planarity of aluminum layer 20 to a greater degree as the width of contact opening 16 decreases. Improvement in planarity of the aluminum layer of interconnect makes it possible to fabricate two or more contacts stacked one above the other. Such a stacked contact is shown in **Figure 3**. The process conditions for completely filling contact vias and allowing for stacking of contacts is especially suitable for use with contact openings having submicron dimensions.

After formation of the aluminum layer 20, the aluminum layer and the barrier layer are patterned and etched using techniques known in the art. A second insulating layer 22, such as plasma oxide, another oxide layer or sandwiched dielectrics as known in the art, is then formed over the surface of the integrated circuit and planarized. A second contact opening 24 is formed in insulating layer 22 followed by the deposition of a second barrier layer 26 over the integrated circuit. At this stage in the process, the barrier layer acts as a diffusion barrier and reduces contact/via resistance. A second aluminum layer is deposited as before. The aluminum layer forms a second level of metal interconnect, which is then patterned and etched to give the structure shown in **Figure 3**.

If desired, a third metal interconnect layer can be fabricated on top of the structure shown in Figure 3 using the techniques described above. Due to the planarization caused by the process conditions described below, multiple interconnect levels are easily fabricated. As device densities increase, stacking contacts allows for complex signal routing to be performed using aluminum interconnect layers.

**Figures 4 and 5** illustrate preferred conditions for deposition of the aluminum layer 20 in order to provide an improved contact. Graph 30 illustrates the deposition rate, in angstroms per second, as a function of the deposition temperature in degrees Celsius. The preferred region 32 lies between 400-500 degrees C, with the maximum deposition rate lying below a line extending from a rate of about 3 nm per second at 400 degrees C to 10 nm per second at 500 degrees C.

When aluminum is deposited within this preferred region 32, its surface migration characteristics are enhanced over metal deposited under other conditions. For example, depositing aluminum at temperatures higher than 500 degrees C tends to form large grains, so that blocking of the contact opening occurs as described earlier. If the deposition rate is too high, the deposited aluminum is not able to migrate quickly enough into the via to completely fill the via. Therefore, the region 32 depicted in **Figure 4** outlines, approximately, a preferred pairing of processing conditions under which deposited aluminum migrates into the contact via and fills the via while minimizing the formation of voids and uneven regions.

Process conditions can be varied slightly from that shown in **Figure 4** without departing from the teachings of the present invention. For example, temperatures slightly below 400 degrees C can be used, as long as the deposition rates are not too high. As the temperature decreases, the mobility of the deposited aluminum atoms goes down. Incomplete filling of the via occurs if the deposition rates are too high.

**Figure 5** includes four graphs illustrating preferred processes by which an aluminum interconnect layer can be formed. All of these processes utilize, to a greater or lesser degree, processing which occurs within the preferred-region 32. Each of the curves 40, 42, 44, 46 illustrates a variation in the aluminum deposition rate with time. Each curve 40-46 illustrates an alternative process utilizing the concepts of the present invention.

Each of the four processes shown in **Figure 5** preferably uses approximately the same set of initial conditions. In the prior art, it is common to deposit a very thin layer of small grain aluminum at a relatively cold temperature, typically below 350 degrees C, and then stop the deposition process. The wafer on which the integrated circuit device is located is then preheated to the required deposition temperature, over 500 degrees C by bathing the wafer with a stream of preheated argon gas. Once the wafer has reached the deposition temperature, deposition of the aluminum is resumed at such elevated temperature.

With the present technique, aluminum is preferably deposited on the device continuously while the device is being heated. Thus, a small amount of aluminum is deposited on the device while the wafer is at or below 350 degrees C. As the wafer gradually heats to the desired deposition temperature, aluminum deposition continues. This process gives a layer of aluminum which is deposited with very small grain sizes, tending to minimize grain size growth at later stages. The deposition temperature is between 400-500 degrees C, and is typically reached in about 40 seconds.

**Figure 5** shows deposition rate curves for four alternative deposition processes. For all of the curves in **Figure 5**, the initial temperature of the wafer is assumed to be approximately 350 degrees C, with the final deposition temperature being 450 degrees C. Heating the wafer to 450 degrees C takes approximately 40 seconds. It will be appreciated by those skilled in the art that different deposition temperatures may be used. Once the wafer has heated to the deposition temperature, the temperature remains constant.

Curve 40 in **Figure 5(a)** depicts a deposition process in which the deposition rate stays constant during the entire course of depositing the aluminum layer 20. Deposition begins when heat is first applied to the wafer in the chamber, and continues while the wafer heats to 450 degrees C and remains there. At a rate of 4 nm per second, an 800 nm thick aluminum layer will take approximately 200 seconds to deposit.

**Figure 5(b)** shows an alternative deposition process in which the deposition rate is performed at 4 nm per second for the first 20 seconds, and 6 nm per second thereafter. The temperature is increasing toward the 450 degree C point during the entire deposition step at 4 nm per second, and for the first 20 seconds at 6 nm per second. For an 8000 angstrom layer, the process curve 42 will result in an aluminum layer formation process which takes approximately 140 seconds.

Curve 44 shows a process in which the initial deposition rate is 4 nm per second, followed by an increase to 8 nm per second after 20 seconds. After approximately one-third of the entire thickness of the aluminum layer has been deposited, the deposition rate is changed to 3 nm per second. This rate is maintained for the deposition of approximately another one-third of the entire layer thickness, followed by an increase of the deposition rate back to 8 nm per second.

The process depicted by curve 44 will take approximately 160 seconds to deposit an 800 nm layer of aluminum. This assumes that 240 nm are deposited during each of the 8 nm per second segments, and during the 3 nm per second segment. The process shown in **Figure 5(c)** provides for an initial fast deposition of aluminum, followed by a slow deposition period in which deposited aluminum is given the opportunity to migrate into the contact opening. The 3 nm deposition period will last for approximately 80 seconds, in order to deposit 240 nm.

Curve 46 in **Figure 5(d)** starts in the same manner as curve 44, but ends with a higher deposition rate. Processing time is saved by the faster deposition near the end of the process. By this point in the deposition process, the contact opening has been mostly filled, and the possibility of voiding in the via has been greatly decreased. Thus, there is no harm to depositing aluminum at a rate which falls outside of the preferred region 32.

It will be appreciated by those skilled in the art that the processes shown in **Figure 5** are illustrative and not definitive. Other variations are possible. The precise combination of deposition temperatures and rates can be varied to suit the requirements and restrictions of the particular processes at hand. For example, if large contact openings only are used, faster deposition rates can be made as the voiding problem is not so critical. For processes such as those illustrated by curves 44, 46, it is not necessary to adhere to a one-third thickness deposition at each rate. These rates and times may be varied to suit the requirements of a production process while still taking advantage of the concepts of the invention.

It is also possible to use the technique of depositing aluminum within the preferred area 32 without continuously depositing aluminum while the wafer temperature is ramping up to the deposition temperature. As is done in the prior art, a thin layer of aluminum can be deposited at relatively cold temperatures, preferably below 350 degrees C. Deposition is then stopped while the wafer is brought to a temperature between 400 and 500 degrees C. Deposition is then resumed at a rate within the preferred region 32, and completed using the teachings set forth above. For example, any of the curves in **Figure 5** can be used, with a difference that the initial 4 nm per second deposition rate is omitted.

Use of the continuous layer formation while the wafer is being heated, combined with deposition at rates and temperatures within the preferred region 32, results in small deposited aluminum grain size and very good filling of the contact via. Filling of the contact via is caused both by the good surface migration characteristics of the deposited aluminum layer at the temperatures and deposition rates described, and because very small initial grain sizes result in smaller final grain sizes, having less tendency to block off the via before it is completely filled.

Due to the planarization caused by the above described process, the top of each of the aluminum contacts is substantially flat which allows multiple interconnect levels to be more easily fabricated than has been the case in the past. A contact to contact connection is thus made similar to a connection between a contact and any other type of interconnect. Filling of the contact vias without voiding provides for good conductivity from the top contact in a stack all the way through to the bottom contact in the stack. Thus, this method of filling the contact vias reduces the overall contact resistance.

## Claims

1. A method of forming interlevel aluminum contacts in integrated circuits, comprising the steps of:

   forming a first insulating layer (14) over a conducting layer (12);
   forming a first contact opening (16) through the insulating layer (14) to expose a portion of the conducting layer (12);
   depositing a first barrier layer (18), selected from a refractory metal alloy, a refractory metal silicide, a refractory metal nitride, a refractory metal or a composite thereof, over the first insulating layer (14) and in the opening (16);
   depositing a first, layer of aluminum (20) continuously on the integrated circuit while the temperature of the integrated circuit is raised from below approximately 350°C to a desired value between approximately 400°C and approximately 500°C;
   after the integrated circuit temperature has reached the desired temperature, depositing the first layer of aluminum (20) on the integrated circuit to desired thickness;
   during the step of depositing the first layer of aluminum (20) to the desired thickness, controlling the rate at which the aluminum is deposited to be less than approximately

   $$(.7 * T) - 251 \text{ nm/sec}$$

   wherein T lies between approximately 400°C and approximately 500°C, wherein deposited aluminum migrates into the opening so as to provide a substantially complete contact fill;
   forming a second insulating layer (22) disposed over the first layer of aluminum (20) and the first insulating layer (22);
   forming a second contact opening (24) in the second insulating layer (22), wherein the second contact opening (24) exposes a portion of the first layer of aluminum (20);
   depositing a second barrier layer (26), selected from a refractory metal alloy, a refractory metal silicide, a refractory metal nitride, a refractory metal or a composite thereof, over the second insulating layer (22) and in the second contact opening (24);
   depositing a second layer of aluminum (28) continuously on the integrated circuit while the temperature of the integrated circuit is raised from below approximately 350°C to a desired value between approximately 400°C and approximately 500°C;
   after the integrated circuit temperature has reached the desired temperature, depositing the second layer of aluminum (28) on the integrated circuit to a desired thickness; and
   during the step of depositing the second layer of aluminum (28) to a desired thickness, controlling the rate at which the aluminum is deposited to be less than approximately

   $$(.7 * T) - 25 \text{ nm/sec}$$

   wherein T lies between approximately 400°C and approximately 500°C, wherein deposited aluminum migrates into the second contact opening (24) so as to provide a substantially complete contact fill.

2. The method of claim 1 wherein the barrier layer is selected from one of a refractory metal/refractory metal nitride composite, a refractory metal/refractory metal silicide composite, or refractory metal silicide/refractory metal nitride composite.

3. The method of claim 1 or 2, wherein the step of forming a second contact opening (24) exposes a portion of the first aluminum layer (20) directly over the first contact opening (16).

4. The method of any one of claims 1 to 3, further comprising the step of, prior to the step of forming a second insulating layer (22), patterning the first aluminum layer (20) to define a first aluminum interconnect layer.

5. The method of any one of claims 1 to 4, wherein the deposition rate is varied, with one portion being faster than approximately 5 nm/sec, and another portion being slower than approximately 5 nm/sec.

6. The method of any one of claims 1 to 5, wherein a last portion of the deposition step is performed at a deposition rate faster than approximately 10 nm/sec.

7. The method of any one of claims 1 to 6, wherein a first deposition portion is performed at a rate above approximately 4 nm/sec.

## Patentansprüche

1. Verfahren zur Ausbildung von Zwischenniveau-Aluminiumkontakten bzw. Zwischenschicht-Aluminiumkontakten in integrierten Schaltungen, das die Schritte aufweist:

   eine erste isolierende Schicht (14) wird über einer leitenden Schicht (12) ausgebildet;
   eine erste Kontaktöffnung (16) wird durch die isolierende Schicht (14) ausgebildet, um einen Abschnitt der leitenden Schicht (12) freizulegen;

eine erste Barriereschicht (18), die aus einer hochschmelzenden bzw. hochwiderstandsfähigen Metalllegierung, einem hochschmelzenden bzw. hochwiderstandfähigen Metallsilizid, einem hochschmelzenden bzw. hochwiderstandsfähigen Metallnitrid, einem hochschmelzenden bzw. hochwiderstandsfähigen Metall oder einer Zusammensetzung davon ausgewählt ist, wird über der ersten isolierenden Schicht (14) und in die Öffnung (16) abgeschieden;

eine erste Schicht aus Aluminium (20) wird kontinuierlich auf der integrierten Schaltung abgeschieden, während die Temperatur der integrierten Schaltung von unterhalb näherungsweise 350 °C auf einen gewünschten Wert zwischen näherungsweise 400 °C und näherungsweise 500 °C angehoben wird;

nachdem die Temperatur der integrierten Schaltung die gewünschte Temperatur erreicht hat, wird die erste Aluminiumschicht (20) auf der integrierten Schaltung bis zu einer gewünschten Dicke abgeschieden;

während des Schrittes zum Abscheiden der ersten Aluminiumschicht (20) bis zu der gewünschten Dicke wird die Rate bzw. Geschwindigkeit gesteuert, mit der das Aluminium abgeschieden wird, um geringer als näherungsweise

$$(.7 * T) - 25 \text{ nm/s}$$

wobei T zwischen näherungsweise 400 °C und näherungsweise 500 °C liegt, wobei abgeschiedenes Aluminium die Öffnung wandert bzw. migriert, um so eine im wesentlichen vollständige Kontaktfüllung zur Verfügung zu stellen;

eine zweite isolierende Schicht (22) ausgebildet, die über der ersten Aluminiumschicht (20) und der ersten isolierenden Schicht (22) abgeschieden ist;

eine zweite Kontaktöffnung (24) wird in der zweiten isolierenden Schicht (22) ausgebildet, wobei die zweite Kontaktöffnung (24) einen Teil der ersten Aluminiumschicht (20) freilegt;

eine zweite Barriereschicht (26), die von einer hochschmelzenden bzw. hochwiderstandsfähigen Metalllegierung, einem hochschmelzenden bzw. hochwiderstandsfähigen Metallsilizid, einem hochschmelzenden bzw. hochwiderstandsfähigen Metallnitrid, einem hochschmelzenden bzw. hochwiderstandsfähigen Metall oder einer Zusammensetzung davon ausgewählt ist, wird über der zweiten isolierenden Schicht (22) und in der zweiten Kontaktöffnung (24) abgeschieden;

eine zweite Aluminiumschicht (28) wird kontinuierlich auf der integrierten Schaltung abgeschieden, während die Temperatur der integrierten Schaltung von unterhalb näherungsweise 350 °C auf einen gewünschten Wert zwischen näherungsweise 400 °C und näherungsweise 500 °C angehoben wird;

nachdem die Temperaratur der integrierten Schaltung die gewünschte Temperatur erreicht hat, wird die zweite Aluminiumschicht (28) auf der integrierten Schaltung bis zu einer gewünschten Dicke abgeschieden; und

während des Schrittes zum Abscheiden der zweiten Aluminiumschicht (28) bis zu einer gewünschten Dicke wird die Rate bzw. Geschwindigkeit, mit der das Aluminium abgeschieden wird, gesteuert, um geringer als näherungsweise

$$(.7 * T) - 25 \text{ nm/s}$$

zu sein,

wobei T zwischen näherungsweise 400 °C und näherungsweise 500 °C liegt, wobei abgeschiedenes Aluminium in die zweite Kontaktöffnung (24) wandert bzw. migriert, um so eine im wesentlichen vollständige Kontaktfüllung zur Verfügung zu stellen.

2.  Verfahren nach Anspruch 1, wobei die Barriereschicht ausgewählt ist von einem der folgenden: Eine hochbelastbare bzw. hochschmelzende Metall-/hochbelastbare bzw. hochschmelzende Metallnitridzusammensetzung bzw. -Verbindung, eine hochbelastbare bzw. hochschmelzende Metall-/hochbelastbare bzw. hochschmelzende Metallsilizzusammensetzung bzw. -verbindung, oder eine hochschmelzende bzw. hochbelastbare Metallsilizid-/hochschmelzende bzw. hochbelastbare Metallnitridverbindung bzw. -zusammensetzung.

3.  Verfahren nach einem der Ansprüche 1 oder 2, wobei der Schritt zum Ausbilden einer zweiten Kontaktöffnung (24) einen Abschnitt der ersten Aluminiumschicht (20) unmittelbar über der ersten Kontaktöffnung (16) freilegt.

4.  Verfahren nach einem der Ansprüche 1 bis 3, das ferner den Schritt aufweist, dass vor dem Schritt zum Ausbilden einer zweiten isolierenden Schicht (22) die erste Aluminiumschicht (20) strukturiert bzw. mit einem Muster versehen wird, um eine erste Aluminium-Zwischenkontaktschicht festzulegen.

5.  Verfahren nach einem der Ansprüche 1 bis 4, wobei die Abscheidungsrate bzw. - geschwindigkeit verändert wird, wobei ein Teil schneller als näherungsweise 5 nm/s ist und ein anderer Teil langsamer als näherungsweise 5 nm/s ist.

**6.** Verfahren nach einem der Ansprüche 1 bis 5, wobei ein letzter Teil des Abscheidungsschrittes mit einer Abscheidungsrate bzw. -geschwindigkeit durchgeführt wird, die schneller als näherungsweise 10 nm/s ist.

**7.** Verfahren nach irgendeinem der Ansprüche 1 bis 6, wobei ein erster Abscheidungsteil bei einer Rate oberhalb näherungsweise 4 nm/s durchgeführt wird.

**Revendications**

**1.** Procédé pour former des contacts inter-niveaux en aluminium dans des circuits intégrés, comprenant les étapes suivantes :

former une première couche isolante (14) sur une couche conductrice (12) ;
former une première ouverture de contact (16) à travers la couche isolante (14) pour exposer une partie de la couche conductrice (12);
déposer une première couche barrière (18), choisie parmi un alliage de métal réfractaire, un siliciure de métal réfractaire, un nitrure de métal réfractaire, un métal réfractaire, ou un composé de ces matériaux, sur la première couche isolante (14) et dans l'ouverture (16) ;
déposer une première couche d'aluminium (20) continûment sur les circuits intégrés tandis que la température du circuit intégré est élevée d'environ moins de 350°C jusqu'à une valeur désirée comprise entre environ 400 et environ 500°C ;
après que la température du circuit a atteint la température désirée, déposer la première couche d'aluminium (20) sur le circuit intégré à une épaisseur désirée ;
pendant l'étape de dépôt de la première couche d'aluminium (20) à l'épaisseur désirée, commander la vitesse à laquelle l'aluminium est déposé pour qu'elle soit inférieure à environ

$$(0,7 * T) - 25 \text{ nm/s}$$

où T est compris entre environ 400 et environ 500°C, l'aluminium déposé migrant dans l'ouverture de façon à fournir un remplissage de contact sensiblement total ;
former une couche isolante (22) déposée sur la première couche d'aluminium (20) et la première couche isolante (14) ;
former une seconde ouverture de contact (24) dans la seconde couche isolante (22), la seconde ouverture de contact (24) exposant une partie de la première couche d'aluminium (20) ;
déposer une seconde couche barrière (26) choisie parmi un alliage de métal réfractaire, un siliciure de métal réfractaire, un nitrure de métal réfractaire, un métal réfractaire, ou un composé de ces matériaux, sur la couche isolante (22) et dans la seconde ouverture de contact (24) ; déposer une seconde couche d'aluminium (28) continûment
sur le circuit intégré tandis que la température du circuit intégré est élevée de moins d'environ 350°C à une valeur désirée comprise entre environ 400 et environ 500°C ;
après que la température du circuit intégré a atteint la température désirée, déposer la seconde couche d'aluminium (28) sur le circuit intégré jusqu'à une épaisseur désirée ; et
pendant l'étape de dépôt de la seconde couche d'aluminium (28) à une épaisseur désirée, commander la vitesse à laquelle l'aluminium est déposé pour qu'elle soit inférieure à environ

$$(0,7 * T) - 25 \text{ nm/s}$$

où T est compris entre environ 400 et environ 500°C, l'aluminium déposé migrant dans la seconde ouverture de contact de façon à fournir un remplissage de contact 24 sensiblement total ;

**2.** Procédé selon la revendication 1, dans lequel la couche barrière est choisie parmi un composé de métal réfractaire et de nitrure de métal réfractaire, un composé de métal réfractaire et de siliciure de métal réfractaire, ou un composé de siliciure de métal réfractaire et de nitrure de métal réfractaire.

**3.** Procédé selon la revendication 1 ou 2, dans lequel l'étape de formation d'une seconde ouverture de contact (24) expose une partie de la première couche d'aluminium (20), directement au-dessus de la première ouverture de contact (16).

**4.** Procédé selon l'une quelconque des revendications 1 à 3, comprenant en outre l'étape consistant, avant l'étape de formation de la couche isolante (22), à graver la première couche d'aluminium (20) pour définir une première couche d'interconnexion en aluminium.

**5.** Procédé selon l'une quelconque des revendications 1 à 4, dans lequel la vitesse de dépôt est modifiée, une partie étant plus rapide qu'environ 5 nm/s et une autre partie étant plus lente qu'environ 5 nm/s.

**6.** Procédé selon l'une quelconque des revendications 1 à 5, dans lequel une dernière partie de l'étape de dépôt est réalisée à une vitesse de dépôt plus rapide qu'environ 10 m/s.

**7.** Procédé selon l'une quelconque des revendications 1 à 6, dans lequel une première partie de dépôt est réalisée à une vitesse supérieure à environ 4 nm/s.

FIG. 1

FIG. 2

FIG. 3

FIG. 4

FIG. 5a

FIG. 5b

FIG. 5c

FIG. 5d